# FASCICULE DE BREVET EUROPEEN

(11) **EP 0 545 820 B1**
(45) Date de publication et mention de la délivrance du brevet: **30.08.1995**
(21) Numéro de dépôt: 92403264.2
(22) Date de dépôt: 03.12.1992
(51) Int. Cl.: H01S 3/06, H01S 3/025, G02B 6/42

(54) **Composant optique semi-conducteur à mode de sortie élargi et son procédé de fabrication**
Optisches Halbleiterbauelement mit einer grösseren Ausgangsfeldfleckverteilung und sein Herstellungsverfahren
Optical semiconductor component with a larger output spotsize distribution and its fabrication method

(30) Priorité: 04.12.1991 FR 9115040
(43) Date de publication de la demande: 09.06.1993
(73) Titulaire: ALCATEL ALSTHOM COMPAGNIE GENERALE D'ELECTRICITE (abrégé: ALCATEL ALSTHOM), 75382 Paris Cédex 08 (FR)
(72) Inventeur: Doussière, Pierre, F-91180 Saint Germain les Arpajons (FR)
(74) Mandataire: Sciaux, Edmond

(56) Documents cités:
- DE-A- 4 010 823
- US-A- 3 978 426
- US-A- 4 111 521
- US-A- 4 773 720
- PATENT ABSTRACTS OF JAPAN vol. 7, no. 222 (E-201)(1367) 4 Octobre 1983 & JP-A-58114476

## Description

La présente invention concerne à la fois la réalisation d'un composant optique semi-conducteur et son couplage à un élément optique qui lui est extérieur. Elle tend plus précisément à résoudre un problème connu qui est d'obtenir simultanément deux résultats. Un premier résultat à obtenir est de "traiter" une lumière avec efficacité dans le composant optique considéré, le mot "traiter" désignant ici des actions telles que émettre, amplifier, détecter ou moduler cette lumière. On considèrera souvent ci-après, à titre d'exemple typique quoique non limitatif, et pour faciliter la comprehension de la présente invention, que le composant optique dans lequel cette lumière est traitée est un laser. La lumière à traiter présente alors la forme d'une onde guidée dans ce laser selon un mode dit étroit dont la taille peut être limitée par des considérations liées à la recherche d'efficacité et au fonctionnement interne de ce laser. Le deuxième résultat à obtenir est que la lumière qui est ainsi traitée soit fournie audit élément optique extérieur ou puisse être efficacement reçue de cet élément sous la forme d'une onde guidée selon un mode élargi présentant une taille plus grande que ce mode étroit. Dans un cas typique un tel mode élargi présente l'avantage de permettre un couplage plus facile et plus efficace de cette onde avec une fibre optique qui reçoit ou fournit la lumière traitée ou à traiter.

Une première solution connue à ce problème est décrite dans un document Koch :
T.L. KOCH, U. KOREN, G. EISENSTEIN, M.G. YOUNG, M. ORON, C.R. GILES and B.I. MILLER
"Tapered waveguide InGaAs/InGaAsp multiple quantum well lasers" IEEE Photonics technology letters, Vol.2, n° 2, February 1990, pp. 88.

Ce document décrit un émetteur laser semi-conducteur fournissant une onde de sortie guidée selon un mode élargi. La réalisation de ce laser est complexe.

Une deuxième solution connue à ce problème est décrite dans un document SHANI :
Y.SHANI, C.H. HENRY, R.C. KISTLER, K.J. ORLOWSKY and D.A. ACKERMAN "Efficient coupling of a semiconductor laser to an optical fiber by means of a tapered waveguide on silicon"
Appl. Phys. lett. 55, December 1989, pp.2389.

Ce document décrit un dispositif de couplage qui reçoit une onde selon un mode étroit en sortie d'un émetteur laser semi-conducteur et qui la transmet selon un mode élargi facilitant le couplage à une fibre optique.

L'insertion d'un tel dispositif complique la réalisation d'une tête optique qui doit coupler l'émetteur laser à la fibre optique dans un espace limité. De plus le positionnement du dispositif de couplage par rapport à l'émetteur laser est délicat.

Une autre solution connue à ce problème est décrite dans le document PATENT ABSTRACT OF JAPAN, vol.7, n°. 222(E-201)(1367), 04/10/1983 of JP-A-58 114 476. Ce document décrit un composant optique semi-conducteur selon le préambule de la revendication 1.

La présente invention a notamment pour but de proposer pour ce problème une solution qui soit simple à réaliser, qui ne nécessite qu'un espace limité, et qui n'entraine que de faibles pertes de lumière. Le composant optique selon l'invention est défini par la revendication 1 et un procédé de fabrication selon l'invention est défini par la revendication 13.

A l'aide des figures schématiques ci-jointes, on va décrire ci-après comment la présente invention peut être mise en oeuvre, étant entendu que les éléments et dispositions mentionnés et représentés ne le sont qu'à titre d'exemples non limitatifs. Lorsqu'un même élément est représenté sur plusieurs figures il y est désigné par le même signe de référence.

La figure 1 représente une vue d'un premier laser en coupe selon un plan transversal I-I de la figure 2.

La figure 2 représente une vue de ce premier laser en coupe partielle selon un plan longitudinal II-II de la figure 1.

La figure 3 représente une vue de ce premier laser en coupe partielle selon un plan horizontal III-III de la figure 1.

Les figures 4, 5 et 6 représentent des vues de ce premier laser en coupe selon le plan transversal I-I à des étapes successives de la fabrication de ce laser.

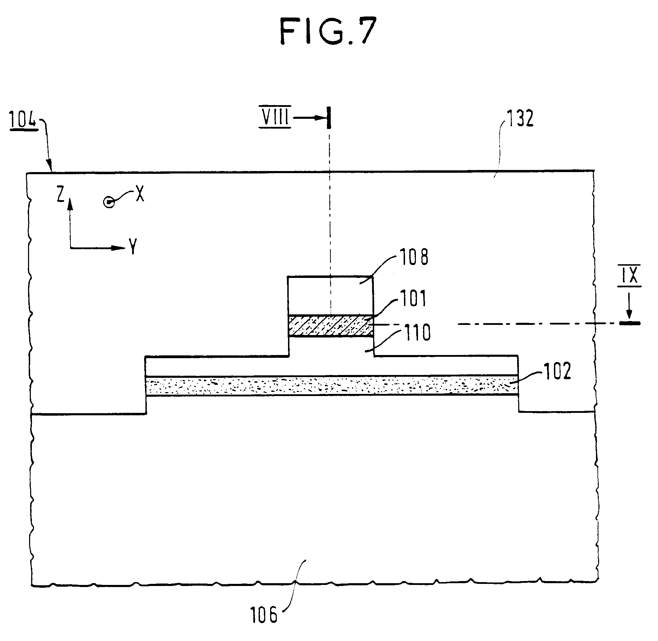

La figure 7 représente une vue d'un deuxième laser selon cette invention, en coupe selon un plan transversal VII-VII de la figure 8.

La figure 8 représente une vue de ce deuxième laser selon cette invention, en coupe partielle selon un plan longitudinal VIII- VIII de la figure 7.

La figure 9 représente une vue de ce deuxième laser en coupe partielle selon un plan horizontal IX - IX de la figure 7.

La figure 10 représente une vue partielle en perspective de ce deuxième laser.

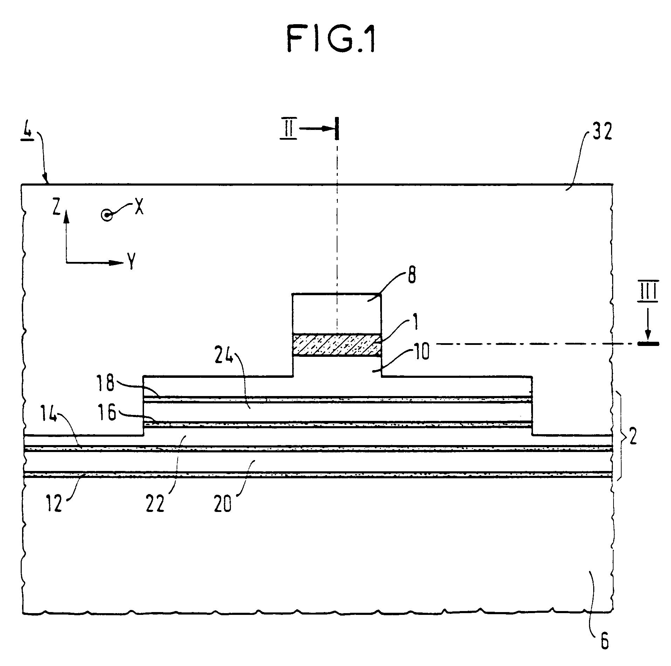

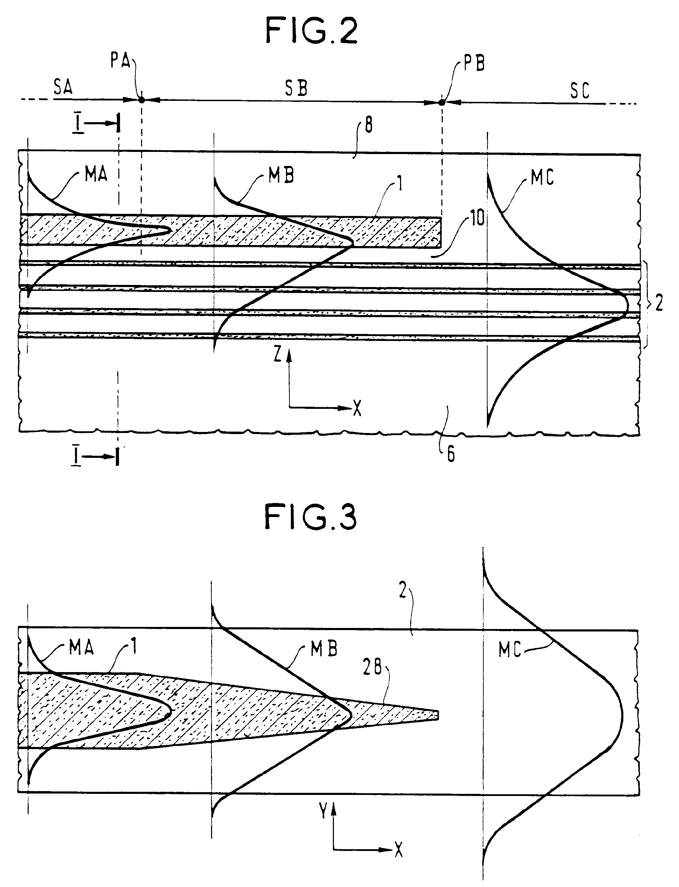

Pour décrire la mise en oeuvre de cette invention on va tout d'abord donner, dans le cas du premier laser et en référant aux figures 1 et 2, la définition de termes qui seront employés par la suite et qui sont définis par rapport à une plaquette semi-conductrice 4 supposée horizontale. Cette plaquette définit deux directions longitudinale X et transversale Y. Des plans horizontaux s'étendent selon ces deux directions. Des plans transversaux sont perpendiculaires à cette direction longitudinale. Cette plaquette définit aussi une direction verticale Z perpendiculaire à ces plans horizontaux. Des longueurs, des largeurs, des épaisseurs et des aires transversales d'éléments internes à cette plaquette seront mesurées selon ces directions longitudinale, transversale et verticale et dans ces plans transversaux, respectivement.

Cette plaquette comporte trois sections successives SA, SB, SC (figure 2) qui s'étendent et se succèdent longitudinalement et qui constituent au moins une section de traitement SA et une section de transition de mode SB. Dans le cas décrit où elle constitue un laser, la section de traitement SA constitue plus particulièrement une section d'amplification. Cette section débute en un point initial de transition PA au voisinage de la section d'amplification et se termine en un point de mode large PB qui constitue en même temps, dans ce premier laser, un point final de transition à distance de cette section. Une troisième section de ce premier laser constitue une section de couplage SC à partir de laquelle le laser peut être couplé à une fibre optique.

Selon des dispositions connues deux faces longitudinalement extrêmes non représentées de cette plaquette peuvent constituer des réflecteurs pour réaliser un émetteur laser. Elles pourraient aussi être traitées pour éviter la réflexion de la lumière et constituer un amplificateur laser qui serait couplé à deux fibres optiques d'entrée et de sortie et qui comporterait pour cela deux sections de transition de mode et deux sections de couplage de part et d'autre de la section d'amplification.

On va maintenant décrire de manière générale certaines dispositions qui sont adoptées dans les lasers donnés en exemple et qui leur sont communes, quant aux fonctions indiquées, avec le laser du document Koch précédemment cité.

Conformément à ces dispositions communes la plaquette 4 comporte une succession verticale de couches fonctionnelles horizontales qui constituent au moins les éléments suivants :
- Une couche de confinement inférieure 6 d'un premier type de conductivité.
- Un guide passif 2 s'étendant longitudinalement et encadré transversalement par une matière complémentaire 32. Pour lui permettre de guider des ondes lumineuses, ce guide présente un indice de réfraction qui est "accru" c'est-à-dire supérieur aux indices de réfraction des matériaux environnants. Cet indice, une largeur normale et une épaisseur de ce guide sont choisis pour guider cette lumière selon un mode unique qui constitue un mode "large" MC.
- Un guide actif 1 s'étendant longitudinalement et encadré transversalement par une matière complémentaire 32. Ce guide est constitué d'un matériau actif qui présente un indice de réfraction accru pour guider ladite lumière et qui est de plus apte à traiter cette lumière par interaction avec des porteurs de charges de types opposés et, plus particulièrement, à amplifier cette lumière par combinaison de tels porteurs. Ce guide actif est constitué d'une seule couche semi-conductrice mais pourrait être constitué par une succession verticale de telles couches de compositions différentes. Les guides passif et actif sont mutuellement superposés. Leurs largeurs, épaisseurs, indices de réfraction et distance mutuelle sont choisis pour réaliser un couplage optique mutuel entre ces guides dans les sections d'amplification SA et de transition de mode SB, et pour que l'ensemble de ces guides guide ladite lumière dans cette section d'amplification selon un mode unique qui concentre l'énergie de cette lumière dans ce guide actif pour favoriser son amplification. Ce mode unique constitue un mode étroit dont une taille est plus petite que celle dudit mode large MC. La largeur et l'épaisseur du guide actif 1 dans la section d'amplification SA définissent une aire transversale de traitement. Dans la section de transition de mode SB et à partir du point initial de transition PA, l'aire transversale de ce guide décroît progressivement à partir de cette aire transversale de traitement pour que la lumière qui est guidée au voisinage de ce point selon le mode étroit soit guidée par le guide passif selon le mode large MC au voisinage du point dit de mode large PB. Quant au guide passif 2 il s'étend avec des caractéristiques constantes dans les sections d'amplification et au moins jusqu'au point de mode large. Dans ce premier laser il conserve ces caractéristiques sur toute la longueur de la plaquette 4.

La propagation de la lumière selon le mode étroit permet son amplification efficace et éventuellement peu sensible à sa polarisation dans la section d'amplification. Le mode large facilite le couplage à une fibre optique.

La plaquette 4 comporte encore, à titre essentiel, une couche de confinement supérieure 8 présentant un deuxième type de conductivité opposé au premier pour que le passage d'un courant électrique d'alimentation d'un sens direct entre ces couches de confinement inférieure et supérieure s'accompagne de l'injection de dits porteurs de charges de types opposés dans le guide actif 1 dans la section d'amplification SA.

On comprendra que la matière complémentaire 32 comporte diverses couches bien connues qui sont utiles pour le fonctionnement du laser et qui ne sont pas représentées. Il s'agit notamment des couches latérales de confinement optique et électrique, des couches de contact etc... Par ailleurs la plaquette est munie d'électrodes non représentées pour permettre d'injecter le courant électrique d'alimentation.

On va maintenant indiquer d'une manière un peu plus particulières d'autres dites dispositions communes.

Dans la section d'amplification SA ou au moins au point initial de transition, le guide passif 2 présente une largeur dite "normale" qui est supérieure ou égale à la largeur du guide actif 1. Il présente aussi une épaisseur qui est supérieure ou égal et un indice de réfraction moyen qui est inférieur, à l'épaisseur et à l'indice de réfraction présentés par ce guide actif, respectivement. Plus précisément l'indice moyen du guide passif est choisi suffisamment proche de celui du matériau environnant pour que le mode étroit soit essentiellement guidé par le guide actif dans la section SA.

Le point de mode large PB constitue une extrémité du guide actif 1.

Le mode large MC présente des tailles transversale et verticale supérieures à 200% et de préférence à 400% de tailles transversale et verticale du mode étroit MA. Ces tailles de chacun de ces modes sont classiquement définies comme étant les dimensions transversale et verticale du domaine dans lequel le champ électrique de ce mode est affaibli dans un rapport inférieur à 2,718 par rapport au champ électrique maximal de ce mode, respectivement.

Dans le laser du document KOCH la décroissance de l'aire transversale du guide actif dans la section de transition de mode est réalisée par une succession longitudinale de diminutions brusques de l'épaisseur de ce guide. Cette disposition présente certains inconvénients : Elle provoque des pertes de lumière. Et sa réalisation nécessite une succession d'étapes de gravure coûteuses.

Ces inconvénients peuvent être très simplement évités totalement grâce au fait que le guide actif 1 peut présenter une épaisseur constante dans la section de transition de mode SB, la décroissance de sa section transversale étant obtenue alors exclusivement par le fait que sa largeur décroît progressivement à partir du point initial de transition PA jusqu'au point de mode large PB. Ces inconvénients pourraient cependant aussi n'être évités que partiellement, la décroissance de section transversale résultant alors à la fois d'une décroissance de largeur et d'une décroissance d'épaisseur.

Par ailleurs une couche de séparation 10 est de préférence interposée entre les deux guides actif 1 et passif 2. Elle présente un indice de réfraction plus bas que l'indice de réfraction moyen de chacun de ces deux guides. Son épaisseur constitue une épaisseur de séparation qui est choisie assez grande pour permettre de limiter transversalement le guide actif, c'est-à-dire de définir sa largeur, par une opération de gravure, tout en évitant le risque que cette opération de gravure atteigne le guide passif, qui, dans la section de transition, doit être plus large pour des raisons qui apparaîtront ci-après. Cette épaisseur est en même temps choisie suffisamment petite pour maintenir le couplage optique nécessaire entre les guides actif et passif.

Le guide actif 1 présente, dans la section de transition de mode SB et en projection sur un plan horizontal, la forme générale d'une pointe à extrémité coupée 28, c'est-à-dire que sa largeur se réduit progressivement jusqu'à une largeur finale suffisamment faible pour que son influence sur le mode de propagation de la lumière devienne négligeable devant celle du guide 2. Cette influence apparaît sur les figures 2 et 3 qui représentent très approximativement des diagrammes de répartitions d'énergie correspondant au mode étroit MA, à une répartition intermédiaire MB et au mode large MC. Chacune de ces répartitions est représentée par deux diagrammes l'un sur la figure 2 l'autre sur la figure 3. Chacun de ces diagrammes comporte une courbe et un axe de référence. Cet axe de référence représente une ligne d'un plan vertical transversal passant dans la plaquette 4, cette ligne passant par le point de ce plan où la valeur du champ électrique alternatif du mode optique guidé est maximale. En chacun des points de cette ligne on détermine la valeur de ce champ électrique et le carré de cette valeur est porté parallèlement à la direction longitudinale X pour marquer un point de la courbe de ce diagramme. Ces diagrammes représentent donc ces modes en montrant la répartition des champs électriques de ces modes.

Il apparaît de ces diagrammes que la décroissance de la largeur du guide 1 provoque une diminution du confinement du mode optique guidé dans le guide 1 ainsi qu'un "glissement" progressif de ce mode vers le guide 2. Ce glissement s'accompagne d'une dilatation due à l'indice de réfraction moyen plus faible du guide 2. La longueur de la zone de décroissance doit être suffisante pour assurer la petitesse souhaitée des pertes de transition (de 50 à 200 micromètres dans le cas d'une longueur d'onde de l'ordre de 0,8 à 1,6 micromètre).

Le fait que les deux guides soient superposés rend le composant optique particulièrement adapté à une réalisation par des techniques de croissance épitaxiale usuelles. Dès lors il devient possible de réaliser des composants optiquement actifs, incluant le transfert du mode d'un guide actif (guide 1) à guidage fort (saut d'indice d'au moins 10⁻¹ ) vers un guide passif (guide 2) à guidage faible (saut d'indice d'au plus 10⁻² ) par une section de transition adiabatique continue, autorisant de faibles pertes, sur un même substrat.

Le choix d'un rétrécissement latéral du guide 1 autorise la réalisation de la section de transition et du guide actif dans une seule et même étape de masquage et gravure. Il combine cet avantage avec ceux de solutions déjà proposées jusqu'alors nécessitant des étapes de masquage multiples (document KOCH) ou ne permettant que la réalisation de composants passifs (document SHANI).

La présente invention peut donc trouver des applications importantes dans la réalisation de composants optoélectroniques semi-conducteurs actifs pour les systèmes de transmissions par fibres optiques monomodes. De tels composants peuvent notamment constituer des émetteurs, amplificateurs, modulateurs. Ils sont désignés globalement ici par le terme "laser".

Dans le premier laser selon la présente invention le guide passif 2 est constitué par une succession verticale de couches d'élévation d'indice 12, 14, 16, 18 et de couches d'abaissement d'indice 20, 22, 24. Ces couches d'élévation d'indice présentent des indices de réfraction plus haut que ces couches d'abaissement d'indice de manière à donner à ce guide passif 2, vis-à-vis de ladite lumière, un indice de réfraction moyen compris entre ceux de ces couches d'élévation et d'abaissement d'indice.

La deuxième laser, donné en exemple de la présente invention est généralement identique au premier. Il comporte donc des éléments assurant les mêmes fonctions, ces éléments étant identifiés par les mêmes mots, et les indications données ci-dessus restant valables sauf indications contraires. Lorsqu'un élément de ce deuxième laser assure la même fonction qu'un élément au premier laser il sera désigné ci-après par le même numéro de référence augmenté du nombre 100.

Par rapport à ce premier laser, ce deuxième laser est, de manière générale, caractérisé par le fait que la largeur du guide actif 101 décroît vers l'avant dans une partie arrière TB seulement de la section de transition de mode et que la largeur du guide passif 102 décroît vers l'avant dans une partie avant TC de cette section pour coupler ledit mode large NC à un mode circularisé de taille encore plus grande NE.

Plus précisément la section de transition TB, TC comporte deux parties successives, arrière et avant, constituant une première transition TB et une deuxième transition TC. Cette première transition TB s'étend dudit point initial de transition QA audit point de mode large QB, la largeur dudit guide actif 101 décroissant vers l'avant dans cette première transition. Cette deuxième transition s'étend longitudinalement vers l'avant à partir de ce point de mode large QB jusqu'audit un point terminal de transition QC, la largeur dudit guide passif 102 décroissant vers l'avant dans cette deuxième transition pour que la lumière qui est guidée par ce guide passif selon ledit mode large au voisinage de ce point de mode large soit guidée par ce même guide selon un mode circularisé NE au voisinage de ce point terminal de transition QC. Ce mode circularisé présente des tailles horizontale et verticale accrues par rapport à ce mode large, cette taille verticale étant accrue dans un rapport plus grand que cette taille horizontale.

Selon une disposition préférée, dans la deuxième transition TC, la largeur du guide passif 202 est d'abord égale à une largeur normale de guide passif LN, cette largeur étant mesurée au point de mode large QB, puis cette largeur décroît progressivement jusqu'au point terminal de transition QC où elle devient égale à une largeur réduite de guide passif LR. Dans le laser donné en exemple, cette largeur reste ensuite égale à cette largeur réduite dans une section de couplage TD s'étendant à l'avant de la section de transition jusqu'à une extrémité QD du laser. L'épaisseur de ce guide est constante. Le guide actif est absent à partir du point de mode large QB.

La largeur réduite LR est de préférence inférieure à 60 %, et par exemple égale à 40 % de la largeur normale LN du guide passif 102.

Le guide passif 102 comporte une seule couche d'élévation d'indice. Son épaisseur peut alors être inférieure à celle du guide actif 101.

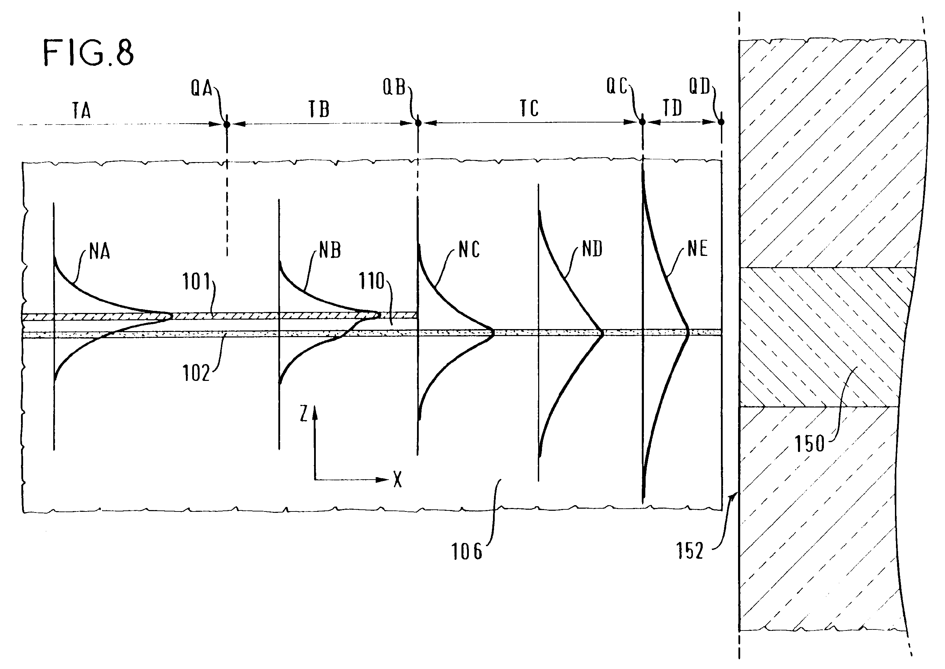

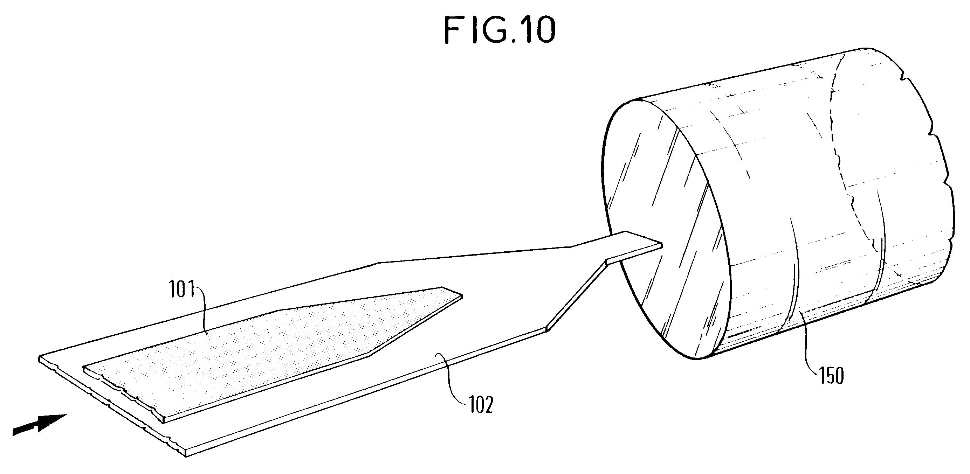

Les figures 8 à 10 montrent en outre le coeur 150 d'une fibre optique monomodale 152 dans laquelle le mode circularisé est injecté.

Le guide actif 101 a par exemple, dans la section de traitement TA, une largeur de 2000 nm et une épaisseur de 100 nm.

Sa largeur finale au point de mode large NC est par exemple de 400 nm, la longueur de la transition arrière TB étant de 0,1 mm. Le guide passif 102 a par exemple une largeur réduite LR de 2000 nm, la longueur de la transition avant TC étant de 0,1 mm.

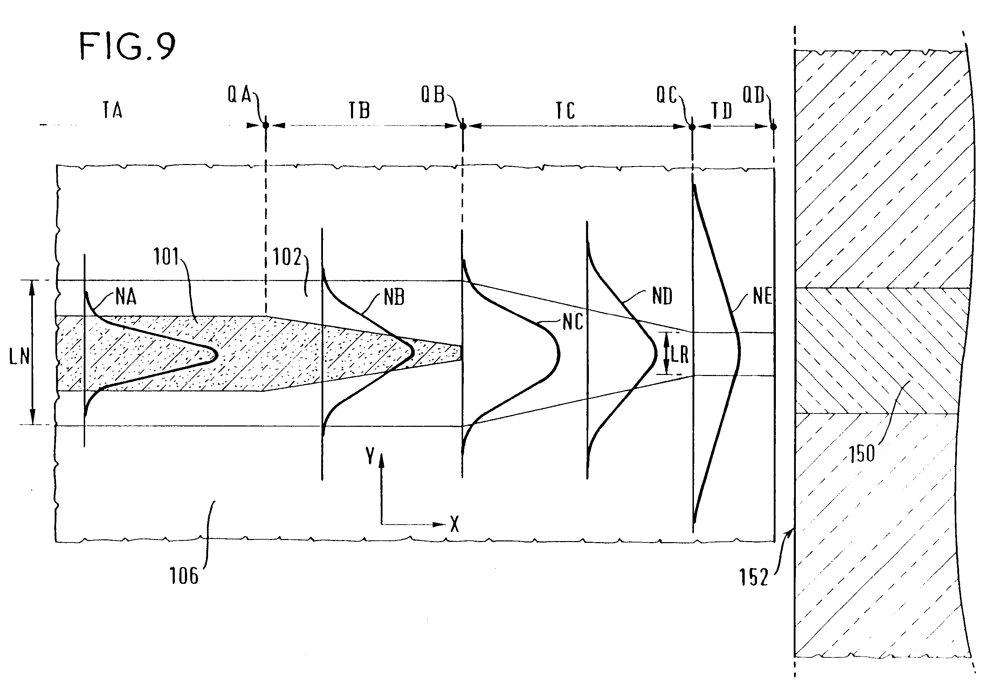

Les figures 8 et 9 représentent, de la même manière que les figures 2 et 3, respectivement, des diagrammes de répartition de l'énergie lumineuse dans les modes guidés par les guides 101 et 102.

Ledit mode étroit est représenté en NA, une première répartition intermédiaire en NB, ledit mode large en NC, une deuxième partition intermédiaire en ND, et ledit mode circularisé en NE.

Les avantages des dispositions adoptées dans ce deuxième laser apparaissent lorsque lorsqu'on considère ce qui suit :

Le but à atteindre est par exemple de réduire la divergence angulaire du faiseau optique émis par un laser semiconducteur de façon à faciliter l'injection de ce faisceau dans un guide externe constitué par une fibre optique. Les meilleures conditions d'injection sont réalisées quand le mode guidé dans le laser à la sortie de celui-ci est identique à celui qui peut être guidé dans le guide externe.

Le diamètre du mode guidé dans un laser semiconducteur est de l'ordre du micron de façon à assurer une interaction lumière/porteurs efficace. Le diamètre du mode guidé par une fibre optique est standardisé à 10 microns de façon à minimiser les pertes de propagation dans la fibre et à faciliter les connexions. Les dispositions adoptées dans le deuxième laser permettent de dilater adiabatiquement le mode de propagation de la lumière à partir du guide actif de façon à obtenir un mode de taille suffisante et de forme sensiblement circulaire au niveau point terminal de transition QC. Immédiatement à l'avant de la transition arrière TB, le mode guidé dans le guide 102 doit être, selon le plan horizontal, presque totalement confiné dans ce guide de façon à constituer une charge guidante aussi grande que possible pour le guidage de la lumière, compte devant être tenu de l'épaisseur de ce guide. Pour atteindre ce résultat, c'est-à-dire pour que la puissance lumineuse du mode glisse du guide 101 vers le guide 102 malgré l'indice de réfraction plus faible de ce dernier, la largeur du guide 102 doit être sensiblement supérieure à celle du guide 101. Il en résulte que le mode propre au guide 102 est nécessairement fortement aplati, sa taille verticale étant plus faible d'un facteur 2 que sa taille horizontale.

Par ailleurs, la dilatation du mode est, à ce stade, insuffisante, surtout dans le plan vertical, pour assurer la qualité de couplage souhaité en sortie du laser. Cette insuffisance de dilatation résulte de l'épaisseur et de l'indice qui sont imposés au guide 102 pour assurer le glissement du mode vers ce guide.

C'est pourquoi, selon la présente invention le guide 102 se prologue au-delà de la transition arrière en réduisant progressivement sa largeur pour circulariser et encore dilater le mode qu'il guide. Sa largeur réduite doit être inférieure à la taille du mode guidé, ceci d'un facteur 2.

La dilatation et la circularisation du mode qu'il guide s'expliquent par le fait qu'en réduisant suffisamment la largeur du guide, on provoque un déconfinement du mode dans le plan horizontal. Dans ces conditions, la répartition du mode dans le plan vertical devient fortement dépendante de son confinement dans le plan horizontal. On dit que les répartitions du mode dans le plan vertical et dans le plan horizontal deviennent fortement interdépendantes, le régime de guidage étant dit "faible". Cette situation s'oppose à celle où le guide est suffisamment large pour que l'on puisse considérer qu'il est infiniment large relativement à son épaisseur. Dans cette dernière situation, les répartitions horizontales et verticales du mode sont indépendantes et le régime de guidage est dit "latéral fort".

La transition doit être répartie sur une longueur suffisante de façon à éviter, une fois encore, les pertes par rayonnement.

Un résultat analogue pourrait être obtenu à l'aide d'une seule transition telle que celle du premier laser donné en exemple. Mais pour cela la longueur de cette transition devrait être égale à la longueur totale de deux transitions décrites plus haut. La réalisation du laser serait alors rendue très délicate du fait des très faibles angles qu'il faudrait donner aux bords du guide actif. Le fonctionnement du laser serait rendu aléatoire parce que l'on ne pourrait pas optimiser séparément la transition du guide 1 vers guide 2 et la circularisation du mode. Au contraire, la limitation de la dilatation du mode dans la première transition du deuxième laser selon cette invention permet de conférer une charge guidante accrue au guide passif 102 compte tenu du fait que la largeur finale du guide actif 101, à son extrémité QB, doit être assez faible pour conférer en ce point à ce guide une charge guidante négligeable par rapport à celle du guide passif 102. Cet accroissement de la charge guidante au guide 102 évite d'avoir à donner à cette largeur finale du guide actif 101 une valeur trop faible pour être facilement et efficacement réalisée. Les tolérances de fabrication sur les dimensions terminales de la pointe formée par le guide 101 sont ainsi relachées. La sensibilité du mode aux imperfections des bords du guide 101 est également diminuée. Ceci permet un fonctionnement plus reproductible du laser.

La présente invention autorise d'autre part un positionnement beaucoup plus tolérant de la fibre par rapport au composant (quelques micromètres) que les lasers connus. Elle permet donc de simplifier la réalisation des têtes optiques qui sont utilisées comme sources optiques dans les réseaux de télécommunications à fibres optiques.

Certaines des indications précédentes s'appliquent aussi pour le report des composants optiquement actifs sur un autre type de composants semiconducteurs (hybridation sur silicium) qui pose le même type de problèmes.

La présente invention peut également trouver une application dans la réalisation d'amplificateurs optiques semi-conducteurs non résonants à rubans enterrés faiblement sensibles à la polarisation du mode guidé. En effet, la petite taille du mode guidé dans le guide actif favorise une faible sensibilité du gain à la polarisation du mode tandis que la taille importante du mode dans le guide passif favorise la diminution de la réflectivité de la face terminale du composant (face clivée) dans le cas où la normale à cette face est désalignée par rapport à l'axe du guide.

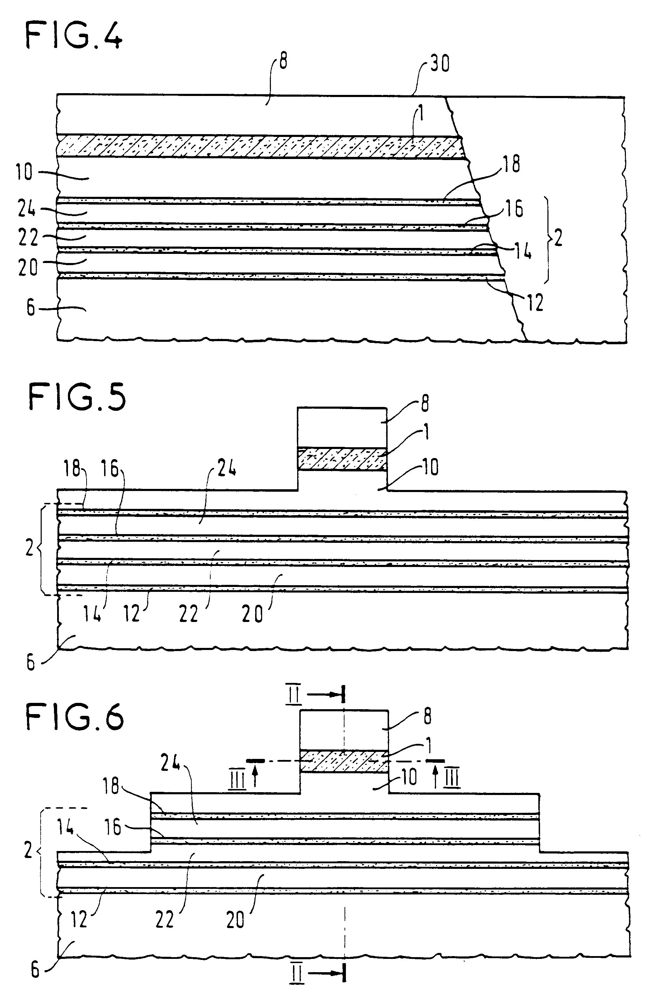

On va maintenant indiquer de manière générale les opérations permettant de fabriquer le premier laser qui a été décrit ci-dessus:
- Une première opération de croissance épitaxiale (figure 4) forme une succession verticale de couches initiales qui constitueront lesdites couches fonctionnelles 6, 2, 10, 1, 8 après limitation transversale des guides actif 1 et passif 2 et qui sont désignées par les mêmes numéros de référence, respectivement.

Cette croissance peut être réalisée par des techniques usuelles de croissance épitaxiale ("Epitaxie par jet moléculaire" (EJM), "Organometallic Chemical Vapor Deposition" (MOCVD), etc...). Le guide 2 peut être constitué d'une couche mince ou, comme précédemment décrit, d'un empilement de couches très minces transparentes d'élévation d'indice 12, 14, 16, 18, séparées par un matériau d'abaissement d'indice identique à celui du substrat (puits dilués). Le choix de l'écartement et du nombre des couches d'élévation d'indice permet de contrôler précisément l'indice de réfraction moyen du guide 2.
- Une première opération de gravure est effectuée à partir d'une face supérieure au moins provisoire 30 de la plaquette qui est située du côté de ladite couche de confinement supérieure 8. Cette opération est poursuivie jusque dans l'épaisseur de la couche de séparation 10. Elle a pour but de limiter transversalement le guide actif 1. La présence de la couche de séparation 10 facilite cette opération.
- Une deuxième opération de gravure pénétre plus loin jusque dans l'épaisseur de la couche initiale 2 pour limiter transversalement le guide passif 2. Cette opération est facilitée par le fait que la largeur du guide 2 est plus grande que celle du guide 1 (figure 6). La profondeur de la gravure permet de contrôler le saut d'indice transversal et d'assurer la propagation d'un seul mode.

Ces deux opérations de gravure sont réalisées par des techniques de masquage classiques appropriées (figure 5).

- On effectue ensuite une deuxième opération de croissance pour enterrer ces guides et les couches de séparation 10 et de confinement supérieure 8 dans la matière complémentaire 32 qui complète la plaquette 4. Cette croissance est de préférence réalisée par épitaxie et peut être sélective ou non (fig.1).

Le deuxième laser donné en exemple peut être fabriqué par la même suite d'opérations, les formes des masques utilisés pour les opérations de gravures devant cependant être modifiées, de même que, éventuellement, les paramètres des opération de croissances épitaxiales.

## Revendications

1. Composant optique semi-conducteur à mode de sortie élargi, ce composant comportant deux guides de lumière s'étendant d'arrière en avant selon une longueur de ce composant pour guider des modes de propagation d'une lumière, ce composant présentant des sections (SA, SB, SC) qui s'étendent et se succèdent longitudinalement dans un sens d'arrière en avant et qui constituent au moins une section de traitement (SA) et une section de transition de mode (SB), cette section de transition débutant en un point initial de transition (PA) au voisinage de cette section de traitement et se terminant en un point final de transition (PB) à distance de cette section, l'un des deuxdits guides étant un guide actif (101) apte à traiter cette lumière, l'autre étant un guide passif (102) s'étendant sous ce guide actif au moins dans la section de transition de mode (TB,TC), la largeur de ce guide actif décroissant vers l'avant dans une partie arrière (TB) de cette section de transition de mode, grâce à quoi un mode "étroit" (NA), guidé par ce guide actif à l'arrière de cette section de transition est couplé à un mode "large" (NC) qui est guidé par ce guide passif dans cette section de transition et qui présente une taille plus grande que ce mode étroit, ce composant étant caractérisé par le fait que la largeur dudit guide passif (102) décroît vers l'avant dans une partie avant (TC) de la section de transition de mode pour coupler ledit mode large à un mode circularisé de taille encore plus grande.

2. Composant selon la revendication 1, ce composant étant constitué par une plaquette semi-conductrice (4), cette plaquette présentant trois directions longitudinale (X), transversale (Y) et verticale (Z) mutuellement perpendiculaires, des plans horizontaux s'étendant selon ces directions longitudinale et transversale, des plans transversaux étant perpendiculaires à cette direction longitudinale, des longueurs, des largeurs, des épaisseurs et des aires transversales d'éléments internes à cette plaquette étant mesurées selon ces directions longitudinale, transversale et verticale et dans ces plans transversaux, respectivement, cette plaquette comportant une succession verticale de couches fonctionnelles horizontales qui constituent, au moins :
- une couche de confinement inférieure (106) d'un premier type de conductivité,
- un guide passif (102) s'étendant longitudinalement et encadré transversalement par une matière complémentaire (132), ce guide présentant un indice de réfraction accru pour guider une lumière, cet indice, une largeur normale et une épaisseur de ce guide étant choisis pour guider cette lumière selon un mode unique constituant un mode "large" (MC),
- un guide actif (101) s'étendant longitudinalement et encadré transversalement par une matière complémentaire (132), ce guide étant constitué d'un matériau actif qui présente un indice de réfraction accru pour guider ladite lumière et qui est de plus apte à traiter cette lumière avec amplification, modulation ou détection de cette lumière par interaction avec des porteurs de charges de types opposés, ces guides passif et actif étant mutuellement superposés et présentant des largeurs, épaisseurs, indices de réfraction et distance mutuelle choisis pour réaliser un couplage optique mutuel entre ces guides et pour que l'ensemble de ces guides guide ladite lumière dans cette section de traitement selon un mode unique qui concentre l'énergie de cette lumière dans ce guide actif et qui favorise ainsi son traitement, ce mode unique constituant un mode étroit dont une taille est plus petite que celle dudit mode large (MC), cette largeur et cette épaisseur de ce guide actif (101) dans cette section de traitement (SA) définissant une aire transversale de traitement, ce guide actif (101) présentant, dans ladite section de transition de mode (SB), à partir dudit point initial de transition (PA), une aire transversale qui décroît vers l'avant à partir de cette aire transversale de traitement pour que la lumière qui est guidée au voisinage de ce point selon ledit mode étroit soit guidée par ledit guide passif selon ledit mode large (MC) en un point de mode large (PB) appartenant à cette section de transition,
- et une couche de confinement supérieure (108) présentant un deuxième type de conductivité opposé au premier pour permettre le déplacement desdits porteurs de charges de types opposés au voisinage du dit guide actif (101) dans ladite section de traitement (SA), lesdits indices de réfraction accrus étant supérieurs aux indices de réfraction desdites couches de confinement inférieure (106) et supérieure (108) et des dites matières complémentaires,
ledit guide actif (101) présentant une épaisseur constante en tous points de ladite section de transition de mode (SB) où ce guide existe, sa largeur décroissant progressivement à partir dudit point initial de transition (PA) jusqu'au dit point de mode large (PB).

3. Composant selon la revendication 2, dans lequel ledit guide passif (102) présente audit point initial de transition (PA) une largeur normale supérieure et un indice de réfraction moyen inférieur à la largeur et à l'indice de réfraction présentés par ledit guide actif (101) dans ladite section de traitement (SA), respectivement.

4. Composant selon la revendication 3, caractérisé par le fait qu'une couche de séparation (110) est interposée entre les deux dits guides actif (101) et passif (102), cette couche de séparation présentant un indice de réfraction plus bas que l'indice de réfraction moyen de chacun de ces deux guides.

5. Composant selon la revendication 2, caractérisé par le fait que ledit point de mode large (PB) constitue une extrémité dudit guide actif (101).

6. Composant selon la revendication 5, dans lequel ledit guide actif (101) présente, dans ladite section de transition de mode (SB), et en projection sur un dit plan horizontal, la forme générale d'une pointe à extrémité coupée (28).

7. Composant selon la revendication 2 dans lequel ledit mode large (MC) présente des tailles transversale et verticale supérieure à 200% de tailles transversale et verticale dudit mode étroit (MA) ces tailles de chacun de ces modes étant les dimensions transversale et verticale du domaine dans lequel le champ électrique de ce mode est affaibli dans un rapport inférieur à 2,718 par rapport au champ électrique maximal de ce mode, respectivement.

8. Composant selon la revendication 7, dans lequel ledit mode large (MC) présente des tailles transversale et verticale supérieures à 400% de tailles transversale et verticale dudit mode étroit (MA), respectivement.

9. Composant selon la revendication 2 caractérisé par le fait que ladite section de transition (TB, TC) comporte une première transition (TB) et une deuxième transition (TC), cette deuxième transition (TB) s'étendant dudit point initial de transition (QA) audit point de mode large (QB), la largeur dudit guide actif (101) décroissant vers l'avant dans cette première transition, cette deuxième transition s'étendant longitudinalement vers l'avant à partir de ce point de mode large (QB) jusqu'au dit point terminal de transition (QC), la largeur dudit guide passif (102) décroissant vers l'avant dans cette deuxième transition pour que la lumière qui est guidée par ce guide passif selon ledit mode large (NC) au voisinage de ce point de mode large soit guidée par ce même guide selon un mode circularisé (NE) au voisinage de ce point terminal de transition (QC), ce mode circularisé présentant des taille horizontale et verticale accrues par rapport à ce mode large, cette taille verticale étant accrue dans un rapport plus grand que cette taille horizontale.

10. Composant selon la revendication 9 caractérisé par le fait que dans ladite deuxième transition (TC), la largeur dudit guide passif (202) est d'abord égale à une largeur normale de guide passif (LN) audit point de mode large (QB) puis décroît progressivement jusqu'au audit point terminal de transition (QC) où elle devient égale à une largeur réduite de guide passif (LR), l'épaisseur de ce guide étant constante, ledit guide actif étant absent.

11. Composant selon la revendication 10 caractérisé par le fait que ladite largeur réduite (LR) de guide passif est inférieure à 60 % de ladite largeur normale de guide passif (LN).

12. Composant selon la revendication 10, caractérisé par le fait qu'il comporte en outre une section de couplage (TD) qui s'étend à l'avant dudit point terminal de transition (QC) et dans laquelle la largeur dudit guide passif (102) reste égale à ladite largeur réduite (LR).

13. Procédé de fabrication d'un composant selon la revendication 4, caractérisé par le fait que la fabrication de ladite plaquette (4) comporte les opérations suivantes :
- une première opération de croissance épitaxiale pour former une succession verticale de couches initiales qui constitueront respectivement lesdites couches fonctionnelles (106, 102, 110, 101, 108) après limitation transversale desdits guides actif (101) et passif (102),
- une première opération de gravure, à partir d'une face supérieure au moins provisoire (30) de ladite plaquette qui est située du côté de ladite couche de confinement supérieure (108), et jusque dans l'épaisseur de ladite couche de séparation (110) pour limiter transversalement ledit guide actif (101),
- une deuxième opération de gravure pénétrant plus loin au moins jusque dans l'épaisseur de ladite couche initiale (102) qui constituera ledit guide passif (102) pour limiter transversalement ce guide,
- et une deuxième opération de croissance pour enterrer ces guides (101, 102) et lesdites couches de séparation (110) et de confinement supérieure (108) dans une matière complèmentaire (132) qui complète ladite plaquette (104).

## Patentansprüche

1. Optisches Halbleiter-Bauelement mit erweitertem Ausgangsmodus und mit zwei Lichtleitern, die sich in Längsrichtung des Bauelements von hinten nach vorne erstrecken, um Ausbreitungsmodi eines Lichts zu führen, wobei das Bauteil Abschnitte (SA, SB, SC) aufweist, die sich in Längsrichtung hintereinander von hinten nach vorne erstrecken und die mindestens einen Verarbeitungsabschnitt (SA) und einen Modus-Übergangsabschnitt (SB) bilden, wobei der Übergangsabschnitt in einem Übergangs-Anfangspunkt (PA) in der Nähe des Verarbeitungsabschnitts beginnt und in einem Übergangs-Endpunkt (PB) entfernt von dem Verarbeitungsabschnitt endet, wobei einer der Lichtleiter ein aktiver Lichtleiter (101) ist, der dieses Licht verarbeiten kann, während der andere ein passiver Lichtleiter (102) ist, der sich unter dem aktiven Lichtleiter zumindest im Modus-Übergangsbereich (TB, TC) erstreckt, wobei die Breite des aktiven Lichtleiters nach vorne hin in einem hinteren Teil (TB) des Modus-Übergangsabschnitts abnimmt, so daß ein enger Modus (NA), der von diesem aktiven Lichtleiter hinter dem Übergangsabschnitt geführt wird, mit einem erweiterten Modus (NC) gekoppelt ist, der im passiven Lichtleiter im Übergangsabschnitt geführt ist und größere Abmessungen als der enge Modus besitzt, dadurch gekennzeichnet, daß die Breite des passiven Lichtleiters (102) nach vorne hin in einem vorderen Teil (TC) des Modus-Übergangsabschnitts abnimmt, um den erweiterten Modus mit einem zirkularisierten Modus noch größerer Abmessungen zu koppeln.

2. Bauelement nach Anspruch 1, bestehend aus einer Halbleiterplatte (4), die eine Längsrichtung (X), eine Querrichtung (Y) und eine vertikale Richtung (Z) besitzt, die aufeinander senkrecht stehen, wobei waagrechte Ebenen sich gemäß den Längs- und Querrichtungen erstrecken und Querebenen senkrecht zu dieser Längsrichtung verlaufen, wobei Längen, Breiten, Dicken und Querabmessungen von inneren Elementen dieser Platte gemäß den Längs-, Quer- und Vertikalrichtungen bzw. den Querebenen gemessen werden und wobei die Platte eine vertikale Folge von funktionalen waagrechten Schichten besitzt, die mindestens bilden:
- eine untere Einschließungsschicht (106) eines ersten Leitfähigkeitstyps,
- einen passiven Lichtleiter (102), der sich in Längsrichtung erstreckt und in Querrichtung von einem komplementären Material (132) eingerahmt ist sowie einen erhöhten Brechungsindex besitzt, um Licht zu führen, wobei dieser Brechungsindex, eine normale Breite und eine Dicke des Lichtleiters so gewählt sind, daß das Licht in einem einzigen Modus geführt wird, der einen erweiterten Modus (MC) bildet,
- einen aktiven Lichtleiter (101), der sich in Längsrichtung erstreckt und in Querrichtung von einem komplementären Material (132) eingerahmt ist, wobei dieser Lichtleiter aus einem aktiven Material besteht, das eine erhöhten Brechungsindex besitzt, um das Licht zu leiten, und der außerdem das Licht durch Verstärkung, Modulation oder Lichtdetektion mittels Wechselwirkung mit Ladungsträgern entgegengesetzter Typen verarbeiten kann, wobei der aktive und der passive Lichtleiter übereinander liegen und Breiten, Dicken, Brechungsindices und einen gegenseitigen Abstand besitzen, die so gewählt sind, daß sich eine wechselseitige optische Kopplung zwischen diesen Lichtleitern ergibt und daß die Einheit aus diesen beiden Lichtleitern das Licht in diesem Verarbeitungsabschnitt gemäß einem einzigen Modus führt, der die Energie des Lichts im aktiven Lichtleiter konzentriert und somit dessen Verarbeitung begünstigt, wobei dieser einzige Modus ein enger Modus ist, dessen Abmessungen kleiner als die des erweiterten Modus (MC) sind, wobei die Breite und die Dicke dieses aktiven Lichtleiters (101) in diesem Verarbeitungsabschnitt (SA) Verarbeitungs-Querabmessungen definieren und der aktive Lichtleiter (101) in dem Modus-Übergangsabschnitt (SB) ausgehend vom Übergangs-Anfangspunkt (PA) Querabmessungen besitzt, die nach vorne hin ausgehend von dem Verarbeitungsquerschnitt abnehmen, damit das Licht, das in der Nähe dieses Punktes gemäß dem engen Modus geführt wird, weiter vom passiven Lichtleiter im erweiterten Modus (MC) zu einem Punkt (PB) mit erweitertem Modus geführt wird, der zum Übergangsabschnitt gehört,
- und eine obere Einschließungsschicht (108), die einen zweiten Leitfähigkeitstyp entgegengesetzt zum ersten besitzt, um die Verschiebung der Ladungsträger entgegengesetzter Typen in der Nähe des aktiven Lichtleiters (101) im Verarbeitungsabschnitt (SA) zu erlauben, wobei die vergrößerten Brechungsindices größer als die Brechungsindices der unteren Einschließungsschicht (106) und der oberen Einschließungsschicht (108) sowie des komplementären Materials sind,
wobei der aktive Lichtleiter (101) eine konstante Dicke in allen Punkten des Modus-Übergangsabschnitts (SB) besitzt, wo dieser Lichtleiter existiert, während seine Breite progressiv ausgehend von dem Übergangsanfangspunkt (PA) bis zum Punkt (PB) des erweiterten Modus abnimmt.

3. Bauelement nach Anspruch 2, in dem der passive Lichtleiter (102) im Übergangsanfangspunkt (PA) eine größere normale Breite als diejenige des aktiven Lichtleiters (101) im Verarbeitungsabschnitt (SA) und einen kleineren Brechungsindex als derjenige des aktiven Lichtleiters (101) in dem Verarbeitungsabschnitt (SA) besitzt.

4. Bauelement nach Anspruch 3, dadurch gekennzeichnet, daß eine Trennschicht (110) zwischen den aktiven und den passiven Lichtleiter (101, 102) eingefügt ist, die einen niedrigeren Brechungsindex als der mittlere Brechungsindex jeder dieser beiden Lichtleiter besitzt.

5. Bauelement nach Anspruch 2, dadurch gekennzeichnet, daß der Punkt (PB) mit erweitertem Modus ein Ende des aktiven Lichtleiters (101) bildet.

6. Bauelement nach Anspruch 5, in dem der aktive Lichtleiter (101) im Modus-Übergangsabschnitt (SB) und in Projektion auf eine waagrechte Ebene die allgemeine Form einer Spitze mit abgeschnittenem Ende (28) besitzt.

7. Bauelement nach Anspruch 2, in dem der erweiterte Modus (MC) Quer- und Vertikalabmessungen besitzt, die größer als 200% der Quer- und Vertikalabmessungen des engen Modus (MA) sind, wobei diese Abmessungen jedes der Modi die Querabmessungen und vertikalen Abmessungen des Bereichs sind, in dem das elektrische Feld dieses Modus um einen Faktor kleiner als 2,718 bezüglich des elektrischen Maximalfelds dieses Modus abgefallen ist.

8. Bauelement nach Anspruch 7, in dem der erweiterte Modus (MC) Quer- und Vertikalabmessungen größer als 400% der Quer- und Vertikalabmessungen des engen Modus (MA) besitzt.

9. Bauelement nach Anspruch 2, dadurch gekennzeichnet, daß der Übergangsabschnitt (TB, TC) einen ersten Übergang (TB) und einen zweiten Übergang (TC) enthält, wobei sich der erste Übergang (TB) vom Übergangsanfangspunkt (QA) bis zum Punkt (QB) mit erweitertem Modus erstreckt und die Breite des aktiven Lichtleiters nach vorne hin im ersten Übergang abnimmt, während der zweite Übergang sich in Längsrichtung nach vorne ausgehend von dem Punkt (QB) mit erweitertem Modus bis zu einem Übergangsendpunkt (QC) erstreckt und die Breite des passiven Lichtleiters (102) nach vorne zu in diesem zweiten Übergang so abnimmt, daß das Licht, das von diesem passiven Lichtleiter gemäß dem erweiterten Modus (NC) in der Nähe des Punktes mit erweitertem Modus geführt wird, von diesem Lichtleiter gemäß einem zirkularisierten Modus (NE) in die Nähe des Übergangsendpunkts (QC) gebracht wird, wobei dieser zirkularisierte Modus nochmals vergrößerte waagrechte und senkrechte Abmessungen bezüglich des erweiterten Modus besitzt und die senkrechte Abmessung in einem größeren Verhältnis als die waagrechte Abmessung vergrößert ist.

10. Bauelement nach Anspruch 9, dadurch gekennzeichnet, daß im zweiten Übergang (TC) die Breite des passiven Lichtleiters (102) zuerst gleich der normalen Breite des passiven Lichtleiters (LN) im Punkt (QB) mit erweitertem Modus ist und dann progressiv bis zum Übergangsendpunkt (QC) abnimmt, wo diese Breite einer verringerten Breite des passiven Lichtleiters (LR) gleicht, wobei die Dicke des Lichtleiters konstant ist und der aktive Lichtleiter nicht mehr vorliegt.

11. Bauelement nach Anspruch 10, dadurch gekennzeichnet, daß die verringerte Breite (LR) des passiven Lichtleiters weniger als 60% der normalen Breite des passiven Lichtleiters (LN) beträgt.

12. Bauelement nach Anspruch 10, dadurch gekennzeichnet, daß es außerdem einen Kopplungsabschnitt (TD) enthält, der sich vom Übergangsendpunkt (QC) nach vorne erstreckt und in dem die Breite des passiven Lichtleiters (102) konstant auf der verringerten Breite (LR) bleibt.

13. Verfahren zur Herstellung eines Bauelements nach Anspruch 4, dadurch gekennzeichnet, daß die Herstellung der Platte (4) folgende Operationen enthält:
- eine erste Operation des epitaxialen Wachstums, um eine vertikale Folge von Ursprungsschichten zu bilden, die die funktionalen Schichten (106, 102, 110, 101, 108) nach der Querbegrenzung der aktiven und passiven Lichtleiter (101, 102) bilden werden,
- eine erste Ätzoperation ausgehend von einer zumindest vorübergehenden Oberseite (30) der Platte, die sich auf der Seite der oberen Einschließungsschicht (108) befindet, wobei die Ätzung bis in die Dicke der Trennschicht (110) reicht, um den aktiven Lichtleiter (101) in Querrichtung zu begrenzen,
- eine zweite Ätzoperation, die tiefer greift, und zwar mindestens bis in die Dicke der ursprünglichen Schicht (102), die dann den passiven Lichtleiter (102) bildet, um diesen Lichtleiter in Querrichtung zu begrenzen,
- und eine zweite Operation des Wachstums, um diese Lichtleiter (101, 102), die Trennschicht (110) und die obere Einschließungsschicht (108) in einem komplementären Material (132) einzubetten, wodurch die Platte (104) vervollständigt wird.

## Claims

1. Widened output mode semiconductor optical component comprising two optical waveguides extending lengthwise of said component from its rear to its front to guide light propagation modes, said component comprising sections (SA, SB, SC) in longitudinal succession in a rear to front direction and which constitute at least one processing section (SA) and one mode transition section (SB), said transition section starting at a transition initial point (PA) in the vicinity of said processing section and ending at a transition final point (PB) at a distance from said section, one of said waveguides being an active waveguide (101) adapted to process light and the other being a passive waveguide (102) underneath said active waveguide at least in the mode transition section (TB, TC) the width of said active waveguide decreasing towards the front in a rear part (TB) of said mode transition section whereby a "narrow" mode (NA) guided by said active waveguide to the rear of said transition section is coupled to a "wide" mode (NC) guided by said passive waveguide in said transition section and which has a mode size greater than that of said narrow mode, said component being characterised in that the width of said active waveguide (102) decreases towards the front in a front part (TC) of the mode transition section so as to couple said wide mode to a circular mode of even greater mode size.

2. Component according to claim 1 comprising a semiconductor wafer (4) having mutually perpendicular longitudinal (X), transverse (Y) and vertical (Z) directions, horizontal planes containing said longitudinal and transverse directions, transverse planes perpendicular to said longitudinal direction, lengths, widths, thicknesses and transverse cross-section areas of internal elements of said wafer being measured in said longitudinal, transverse and vertical directions and in said transverse planes, respectively, said wafer comprising a vertical succession of horizontal functional layers which constitute at least:
- a lower confinement layer (106) having a first conductivity type,
- a longitudinal passive waveguide (102) flanked in the transverse direction by a complementary material (132) and having an increased refractive index to guide light, said index, a normal width and a thickness of said waveguide being chosen to guide said light in a single "wide" mode (MC),
- a longitudinal active waveguide (101) flanked transversely by a complementary material (132) and comprising an active material which has an increased refractive index to guide said light and which is adapted to process said light by amplification, modulation or detection of said light by virtue of interaction with opposite type charge carriers, said passive and active waveguides being superposed and having widths, thicknesses, refractive indices and a mutual spacing chosen to obtain mutual optical coupling between said waveguides and so that light is guided by the combination of said waveguides in said processing section in a single mode which concentrates the energy of said light in said active waveguide and which favours its processing, said single mode constituting a narrow mode one mode size of which is smaller than that of said wide mode (MC), said width and said thickness of said active waveguide (101) in said processing section (SA) defining a processing transverse cross-section area, said active waveguide (101) having in said mode transition section (SB) and starting from said transition initial point (PA) a transverse cross-section area which decreases towards the front from said processing transverse cross-section area so that light guided in the vicinity of said point in said narrow mode is guided by said passive waveguide in said wide mode (MC) at a wide mode point (PB) in said transition section,
- and an upper confinement layer (108) having a second conductivity type opposite the first type to enable displacement of said opposite type charge carriers in the vicinity of said active waveguide (101) into said processing section (SA), said increased refractive indices being greater than the refractive indices of said lower and upper confinement layers (106, 108) and said complementary materials,
said active waveguide (101) has a constant thickness at all points of said mode transition section (SB) in which said waveguide is present, its width decreasing progressively from said transition initial point (PA) to said wide mode point (PB).

3. Component according to claim 2 wherein said passive waveguide (102) has at said transition initial point (PA) a normal width greater than and a mean refractive index less than the width and the refractive index of said active waveguide (101) in said processing section (SA), respectively.

4. Component according to claim 3 characterised in that a separation layer (110) is disposed between said active and passive waveguides (101, 102) and has a refractive index lower than the mean refractive index of each of said waveguides.

5. Component according to claim 2 characterised in that said wide mode point (PB) constitutes one end of said active waveguide (101).

6. Component according to claim 5 wherein said active waveguide (101) has in said mode transition section (SB), projected in a horizontal plane, the general shape of a point (28) with the end cut off.

7. Component according to claim 2 wherein said wide mode (MC) has transverse and vertical mode sizes 200% greater than transverse and vertical mode sizes of said narrow mode (MA), said mode sizes of each of said modes being the transverse and vertical dimensions of the area in which the electric field of said mode is attenuated by a ratio less than 2.718 relative to the maximal electric field of said mode, respectively.

8. Component according to claim 7 wherein said wide mode (MC) has transverse and vertical mode sizes 400% greater than transverse and vertical mode sizes of said narrow mode (MA), respectively.

9. Component according to claim 2 characterised in that said transition section (TB, TC) comprises a first transition (TB) and a second transition (TC), said second transition (TC) extending from said transition initial point (QA) to said wide mode point (QB), the width of said active waveguide (101) decreasing towards the front in said first transition, said second transition extending longitudinally towards the front from said wide mode point (QB) to said transition terminal point (QC), the width of said passive waveguide (102) decreasing towards the front in said second transition so that light guided by said passive waveguide in said wide mode (NC) in the vicinity of said wide mode point is guided by the same waveguide in a circular mode (NE) in the vicinity of said transition terminal point (QC), said circular mode having horizontal and vertical mode sizes increased relative to those of said wide mode, said vertical mode size being increased by a greater ratio than said horizontal mode size.

10. Component according to claim 9 characterised in that the width of said passive waveguide (202) in said second transition (TC) is first equal to a normal passive waveguide width (LN) as far as said wide mode point (QB) and then decreases progressively to said transition terminal point (QC) at which it becomes equal to a reduced passive waveguide width (LR), the thickness of said waveguide being constant, said active waveguide being absent.

11. Component according to claim 10 characterised in that said reduced passive waveguide width (LR) is 60% less than said normal passive waveguide width (LN).

12. Component according to claim 10 characterised in that it further comprises a coupling section (TD) which extends towards the front from said transition terminal point (QC) and wherein the width of said passive waveguide (102) remains equal to said reduced width (LR).

13. Method of fabricating a component according to claim 4 characterised in that the fabrication of said wafer (104) comprises the following operations:
- a first epitaxial growth operation to form a vertical succession of initial layers that will respectively constitute said functional layers (106, 102, 110, 101, 108) after transverse delimitation of said active and passive waveguides (101, 102),
- a first etching operation from an at least temporary upper face (30) of said wafer on the same side as said upper confinement layer (108) into the thickness of said separation layer (110) to delimit said active waveguide (101) transversely,
- a second etching operation penetrating more deeply at least to the thickness of said initial layer (102) that will constitute said passive waveguide (102) to delimit said waveguide transversely,
- and a second growth operation to bury said waveguides (101, 102) and said separation and upper confinement layers (110, 108) in a complementary material (132) which completes said wafer (104).
